# EUROPÄISCHE PATENTANMELDUNG

(11) **EP 2 574 157 A1**
(43) Veröffentlichungstag der Anmeldung: **27.03.2013**
(21) Anmeldenummer: 11182462.9
(22) Anmeldetag: 23.09.2011
(51) Int. Cl.: H05K 7/20

(54) **Leistungselektronikbaugruppe und Anordnung umfassend wenigstens eine solche Leistungselektronikbaugruppe**

(71) Anmelder: AEG Power Solutions B.V., 1161 AH Zwanenburg (NL)
(72) Erfinder: Bajan, Liviu, 72581 Dettingen (DE); El Gharib, Samir, 59581 Warstein (DE); Schulte, Gerrit, 59602 Rüthen (DE)
(74) Vertreter: Graefe, Jörg

(57) **Zusammenfassung**

Die Erfindung betrifft eine Leistungselektronikbaugruppe (1 , 2, 3) mit einem Kühlkörper (2), einem Leistungshalbleitermodul (1) und einer Schaltungsanordnung (3) zum Ansteuern des Leistungshalbleitermoduls, wobei der Kühlkörper (2) wenigstens zwei parallele Kanäle aufweist, die von einem Kühlmedium durchströmbar sind.

## Beschreibung

Die vorliegende Erfindung betrifft eine Leistungselektronikbaugruppe mit einem Kühlkörper, einem Leistungshalbleitermodul und einer Schaltungsanordnung zum Ansteuern des Leistungshalbleitermoduls.

Leistungshalbleitermodule und zugeordnete Schaltungsanordnungen zum Ansteuern der Leistungshalbleitermodule sind heute weit verbreitet. Sie bilden häufig Teile von Stromversorgungen, Umrichtern, insbesondere von Wechselrichtern oder Gleichrichtern, oder anderen elektrotechnischen Anordnungen.

Derzeit ist es üblich, dass für jede Anwendung oder für eine Gruppe von Anwendungen so genannte Stacks (zum Beispiel Prime Stacks der Infineon AG) zu konstruieren. Diese weisen einen Kühlkörper auf, auf dem eine Vielzahl von Leistungshalbleitermodulen und die diesen zugeordneten Schaltungsanordnungen zum Ansteuern derselben angeordnet sind.

Bei der Planung von allen Anwendungen von Leistungselektronik muss der Entwickler ein besonderes Augenmerk auf die Kühlung der leistungselektronischen Bauelemente legen. Je nach thermischer Last kann es erforderlich sein, ein Kühlmedium in flüssiger oder gasförmiger Form zuzuführen, um hinreichend Wärme abzuführen. Die Kühlung der Leistungselektronik wird bei den bekannten Anwendungen individuell ausgeführt. Das steigert die Individualität der Baugruppen.

Das hohe Maß an Individualität und insbesondere der damit verbundene Entwicklungsaufwand verursachen Kosten, die das fertige Produkt verteuern.

Hier setzt die vorliegende Erfindung an.

Der Erfindung liegt die Aufgabe zu Grunde eine
Leistungselektronikbaugruppe vorzuschlagen, die ein hohes Maß an unterschiedlichen Verwendungsmöglichkeiten durch verschiedene Möglichkeiten für eine hinreichende Kühlung bietet.

Diese Aufgabe wird erfindungsgemäß dadurch gelöst, dass der Kühlkörper wenigstens zwei parallele Kanäle aufweist, die von einem Kühlmedium durchströmbar sind.

Die erfindungsgemäße Baugruppe kann auf verschiedene Art und Weise genutzt werden: Zunächst ist bei geringer thermischer Last eine Nutzung der Baugruppe gänzlich ohne ein durch die Kanäle fließendes Kühlmedium möglich. Dann ist die Wärmekapazität und der Wärmetransport durch Strahlung und Konvektion ausreichend, um die erzeugte Wärme abzuführen. Bei größeren thermischen Lasten, kann durch ein durch wenigstens einen Teil der Kanäle geleitetes Kühlmedium Wärme abgeführt werden. Bei dem Medium kann es sich um ein Gas, zum Beispiel Luft, oder eine Flüssigkeit, zum Beispiel Wasser oder Öl, handeln. Insbesondere bei großen thermischen Lasten wird vorzugsweise eine Flüssigkeit durch wenigstens einen Teil der Kanäle geleitet.

Die Kühlleistung kann bei Verwendung eines Kühlkörpers für verschiedene Anwendungen angepasst werden.

Die parallele Ausführung der Kanäle erleichtert die Herstellung der Kühlkörper, die in Regel entsprechende Ausführung eines Strangpressprofils oder durch spanende Bearbeitung, zum Beispiel Bohren oder Fräsen aus einem Aluminiumblock hergestellt werden.

Die Kanäle können durch wenigstens einen ersten Verbindungskanal miteinander verbunden sein. Durch diese Verbindungskanäle ist ein

Verbinden der Kanäle innerhalb des Kühlkörpers möglich.. Die Verbindungskanäle können durch Bohren oder andere geeignete Bearbeitung hergestellt werden. Die Kanäle können fluidisch parallel oder in Reihe geschaltet werden. Die Reihenschaltung kann innerhalb des Kühlkörpers oder mit Hilfe von außerhalb des Kühlkörpers liegenden, die Kanäle verbindende Leitungen erfolgen.

In dem Kühlkörper einer erfindungsgemäßen
Leistungselektronikbaugruppe kann eine erste Anzahl von ersten benachbarten Kanälen der Kanäle Hinleitungskanäle bilden, die Endbereiche aufweisen, die über den ersten Verbindungskanal miteinander verbunden sind. Eine zweite Anzahl von zweiten benachbarten Kanälen der Kanäle kann Rückleitungskanäle bilden, die Anfangsbereiche aufweisen, die über den ersten Verbindungskanal miteinander und mit den Endbereichen der Hinleitungskanäle verbunden sind. Die Hinleitungskanäle und die Rückleitungskanäle können über die Verbindung mittels des Verbindungskanals fluidisch in Reihe geschaltet sein. Die erste Anzahl und die zweite Anzahl können gleich groß sein.

Anfangsbereiche der Hinleitungskanäle können über einen zweiten Verbindungskanal verbunden sein und Endbereiche der Rückleitungskanäle über dritte Verbindungskanäle verbunden sein.

Im Anfangsbereich der Hinleitungskanäle und im Endbereich der Rückleitungskanäle sind vorzugsweise Anschlüsse vorgesehen, mit denen die Kanäle an Zuleitungen oder Ableitungen angeschlossen werden können.

Die Kanäle und/oder die Verbindungskanäle im Kühlkörper einer erfindungsgemäßen Leistungselektronikbaugruppe können Abschnitte von Durchgangslöchern und/oder Sacklöchern in einem den Kühlkörper bildenden Block sein. Durch Stopfen, Schrauben oder Ähnliches können die Abschnitte der Durchgangslöcher und/oder Sacklöcher abgegrenzt sein. Die Durchgangslöcher und/oder Sacklöcher können durch die Stopfen, Schrauben oder Ähnliches in einen oder mehrere Kanäle bildende Abschnitte unterteilt sein. Damit ist es möglich, den mit den Durchgangs- und/oder Sacklöchern versehenen Block an die individuellen Anforderungen einer mit dem Block als Kühlkörper herzustellenden Leistungselektronikbaugruppe anzupassen, ohne dass eine vollständige Neukonstruktion eines Kühlkörpers notwendig ist.

Die Stopfen, Schrauben oder Ähnliches können eingeklebt oder lösbar in dem Block eingesetzt sein.

Durch ein Setzen oder Herausnehmen von Stopfen, Schrauben oder Ähnlichem können die Kanäle in dem Kühlkörper konfiguriert werden. Es ist damit möglich verschiedene Kanalsysteme zu konfigurieren, die einer Anpassung des Kühlkörpers an unterschiedliche thermische Lasten dienen können.

Ebenso wie die Stopfen, Schrauben oder Ähnliches können Anschlussstutzen lösbar in dem Block eingesetzt werden, um an verschiedenen Stellen Einlässe oder Auslässe für das Kühlmedium zu schaffen.

Vorzugsweise können die Stopfen und die Anschlussstutzen wahlweise in das Ende eines der Löcher (Durchgangslöcher oder Sacklöcher) eingesetzt werden.

Das Leistungshalbleitermodul ist vorzugsweise auf dem Kühlkörper befestigt, womit ein guter Wärmetransport vom
Leistungshalbleitermodul zum Kühlkörper gewährleistet wird.

Die Schaltungsanordnung zum Ansteuern des
Leistungshalbleitermoduls kann auf einem Schaltungsträger angeordnet sein, der über Abstandhalter mit Abstand zu einer Oberfläche des Kühlkörpers an dem Kühlkörper befestigt sein kann. Der Schaltungsträger kann einen Ausschnitt aufweisen, in welchen das Leistungshalbleitermodul hinein- oder hindurchragt.

Der Kühlkörper einer erfindungsgemäßen
Leistungselektronikbaugruppe kann auf einer dem
Leistungshalbleitermodul abgewandten Seite wenigstens eine Nut, wenigstens eines Bohrung, insbesondere mit einem Innengewinde, wenigstens einen Schraubkanal oder anderes aufweisen, in welcher bzw. welchem Befestigungsmittel zur Befestigung der Leistungselektronikbaugruppe an einem Träger vorgesehen sind.

Eine erfindungsgemäße Leistungselektronikbaugruppe weist vorteilhaft genau ein Leistungshalbleitermodul und genau eine Schaltungsanordnung zum Ansteuern genau diesen Moduls auf. In der Regel lässt sich mit einer solchen erfindungsgemäßen Leistungselektronikbaugruppe keine vollständige leistungselektronische Anordnung, zum Beispiel ein Umrichter realisieren. Für eine erfindungsgemäße Anordnung werden daher mehrere, wenigstens zwei erfindungsgemäße
Leistungselektronikbaugruppen verwendet.

Möglich ist aber, dass eine erfindungsgemäße
Leistungselektronikbaugruppe zwei unterschiedliche Leistungshalbleitermodule auf einem Kühlkörper aufweist, wobei die Leistungshalbleitermodule vorzugsweise in verschiedenen Umrichtern verwendet werden. Dieses ist insbesondere für Anordnungen interessant bei denen zwei Umrichter, nämlich ein eingangsseitiger und ein ausgangsseitiger Umrichter realisiert sind, wie zum Beispiel bei einem Frequenzumrichter, der einen Gleichrichter, einen Gleichspannungszwischenkreis und einen Wechselrichter aufweist. Da die Leistungselektronikbaugruppe dann vorteilhaft jeweils nur ein Leistungshalbleitermodul des eingangsseitigen Umrichters und ein Leistungshalbleitermodul des ausgangsseitigen Umrichters aufweist, muss die erfindungsgemäße Anordnung auch dann mehrere Leistungshalbleitermodule aufweisen. Es kann notwendig sein, dass der Kühlkörper zur Befestigung von zwei Leistungshalbleitermodulen auf besondere Art und Weise ausgebildet ist, zum Beispiel auf zwei Seiten des Kühlkörpers plane Flächen vorgesehen sind. Diese können durch eine weitere Bearbeitung eines Kühlkörpers hergestellt werden oder von vornherein vorgesehen sein.

Die Leistungselektronikbaugruppen können so zu einander angeordnet sein, dass die Kanäle parallel zu einander liegen.

Die Anordnung kann Zuleitungen und Ableitungen für ein Kühlmedium aufweisen, die über in den Anfangsbereichen der Hinleitungskanäle bzw. in den Endbereichen der Rückleitungskanäle vorgesehene Anschlüsse an die Hinleitungskanäle bzw. die Rückleitungskanäle angeschlossen sind.

Die Leistungselektronikbaugruppen können fluidisch parallel geschaltet sein.

Die Leistungselektronikbaugruppen einer erfindungsgemäßen Anordnung können gleich sein.

Die Leistungselektronikbaugruppen können auf wenigstens einem Träger, zum Beispiel einer Tragschiene montiert sein.

Ein Ausführungsbeispiel einer erfindungsgemäßen
leistungselektronischen Baugruppe und eine Anordnung umfassend zwei dieser Baugruppen wird anhand der Zeichnungen näher erläutert. Es zeigt
- Fig. 1: eine perspektivische Darstellung der erfindungsgemäßen Anordnung,
- Fig. 2a bis 2c: die leistungselektronische Baugruppe in verschiedenen Ansichten und

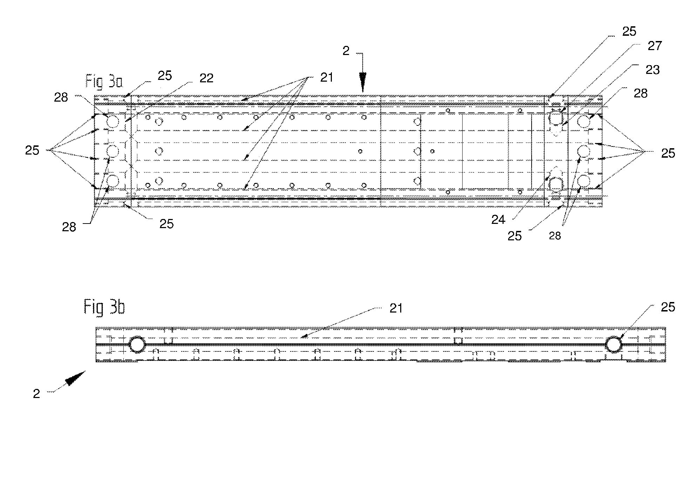

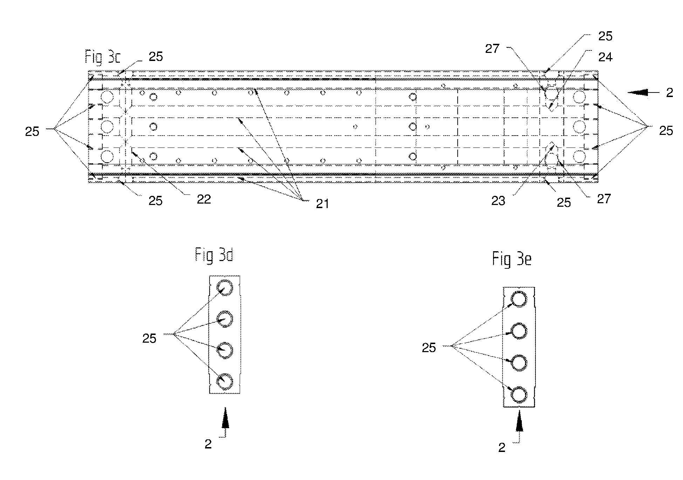

- Fig. 3a bis 3e: einen Kühlkörper der leistungselektronischen Baugruppe gemäß der Figuren 2a bis 2c in verschiedenen Ansichten.

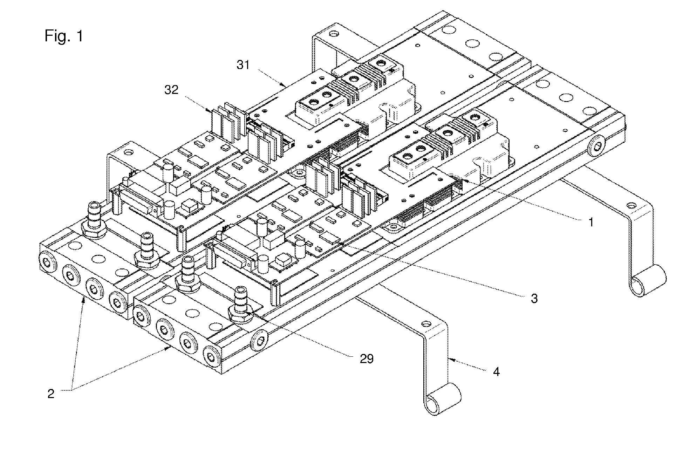

Eine erfindungsgemäße Anordnung kann beispielsweise Teil eines Frequenzumrichters sein. Ein üblicher Frequenzumrichter hat einen Eingangsgleichrichter, einen Gleichspannungszwischenkreis und einen Ausgangswechselrichter. Die in der Figur 1 dargestellte beispielhafte erfindungsgemäße Anordnung bildet den Ausgangswechselrichter A eines Frequenzumrichters. Erfindungsgemäße Anordnungen können aber auch andere Schaltungen bilden.

Der Ausgangswechselrichter A erzeugt aus Gleichstrom des Gleichspannungszwischenkreises einen einphasigen Wechselstrom. Zur Erzeugung des Wechselstroms weist der Ausgangswechselrichter Bipolartransistoren mit isolierten Gate-Elektroden (IGBTs) auf, die in einer H-Schaltung geschaltet sind. Diese bekannte Schaltung zur Erzeugung von einphasigem Wechselstrom benötigt vier IGBTs. Je zwei IGBTs sind in einem Leistungshalbleitermodul 1 untergebracht. Derartige Leistungshalbleitermodule 1 werden von verschiedenen Herstellern angeboten.

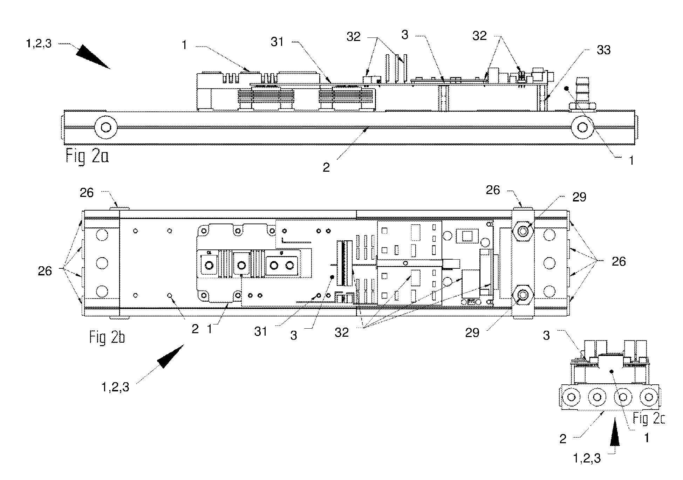

Die Leistungshalbleitermodule 1 sind mit einer Schaltungsanordnung 3 zum Ansteuern der Leistungshalbleitermodule 1 , die einen Schaltungsträger 31 und darauf angeordnete Bauelemente 32 umfasst, und mit einem Kühlkörper 2 zu einer erfindungsgemäßen Leistungselektronikbaugruppe 1, 2, 3 zusammengefasst (siehe Fig. 2a bis 2b). Die erfindungsgemäße Anordnung A weist zwei solcher Leistungselektronikbaugruppen 1 , 2, 3 auf, die auf zwei Tragschienen 4 montiert sind.

Erfindungsgemäße Leistungselektronikbaugruppen können auch andere Leistungshalbleitermodule als IGBT-Leistungshalbleitermodule umfassen. Eine Erfindungsgemäße Anordnung kann auch mehr als zwei Leistungselektronikbaugruppen aufweisen.

Es ist möglich mit erfindungsgemäßen Leistungselektronikbaugruppen 1, 2, 3 verschiedene Schaltungen zu realisieren. So können z. B. die IGBTs der IGBT-Leistungselektronikbaugruppen in der erwähnten H-Schaltung aber auch in einer anderen Brückenschaltung oder in einer beliebigen Mittelpunktsschaltung geschaltet werden. Die IGBT-Leistungselektronikbaugruppen selbst müssen bestenfalls nicht oder nur unwesentlich geändert werden. Einfache Änderungen können durch eine entsprechende Programmierung vorgenommen werden.
Gegebenenfalls ist auch eine Bauteiländerung der
Schaltungsanordnung 3 zum Ansteuern notwendig. Im aufwändigsten Fall ist ein vollständiger Tausch der Schaltungsanordnung 3 zum Ansteuern erforderlich. Eine Änderung des Kühlkörpers 2 ist nur dann erforderlich, wenn die thermische Last sich ändert, zum Beispiel weil zusätzliche Leistungshalbleitermodule angebracht werden sollen. Änderungen des Kühlkörpers können aber einfach realisiert werden, was noch erläutert wird.

Insbesondere die Zuordnung des Kühlkörpers 2 zu einem Leistungshalbleitermodul macht diese einfachen Änderungen einer erfindungsgemäßen Anordnung, insbesondere auch einer einfachen Skalierbarkeit einer erfindungsgemäßen Anordnung möglich.

Das Leistungshalbleitermodul 1 ist vorzugsweise unmittelbar auf dem Kühlkörper 2 angebracht, so dass ein möglichst guter Wärmeübergang vom thermisch stark belasteten Leistungshalbleitermodul 1 zum Kühlkörper möglich ist.

Die Schaltungsanordnung 3 ist vorzugsweise über Abstandhalter 33 auf dem Kühlkörper befestigt, wobei der Schaltungsträger 31 der Schaltungsanordnung 3 einen Ausschnitt aufweisen kann, durch welchen Teile des Leistungshalbleitermoduls 1 durchragen.

Der Kühlkörper 2 ist so gestaltet, dass er einfach an unterschiedliche thermische Lasten angepasst werden kann.

Der Kühlkörper ist aus einem Aluminiumstrangpressprofil hergestellt.
Das Strangpressprofil wird dazu mit vier parallelen sich in Längsrichtung erstreckenden ersten Löchern, nämlich Durchgangslöchern 21 hergestellt. In einem Endbereich dieser Durchgangslöcher 21 und quer zu den ersten Durchgangslöchern 21 ist der das Strangpressprofil mit einem zweiten Loch, nämlich einem Durchgangsloch 22 versehen, welches die ersten Durchgangslöcher 21 schneidet. In einem dem zweiten Durchgangsloch 22 gegenüberliegenden Endbereich werden von zwei verschiedenen Seiten ein drittes Loch, nämlich ein Sackloch 23 und ein viertes Loch, nämlich ein Sackloch 24 eingebracht, die jeweils zwei der ersten Durchgangslöcher 21 schneiden.

An den Enden der Durchgangslöcher 21, 22 und den Enden der Sacklöchern 23, 24 sind Gewinde 25 eingeschnitten, in welche Stopfen 26 eingeschraubt und/oder eingeklebt sind, die die Löcher 21 , 22, 23, 24 verschließen.

Von einer Oberseite des Kühlkörpers sind weitere Sacklöcher eingebracht, welche im dritten Loch 23 und dem vierten Loch 24 münden. In diese weiteren Sacklöcher sind Anschlussstutzen 29 eingesetzt. Diese Anschlussstutzen 29 bilden einen Einlass und einen Auslass, des durch die Löcher 21, 22, 23, 24 in dem Quader gebildeten Kanalsystems aus Kanälen (gebildet durch Abschnitte der ersten Löcher 21), einem ersten Verbindungskanal (gebildet durch einen Abschnitt des zweiten Lochs 22), einen dritten Verbindungskanal (gebildet durch einen Abschnitt des dritten Lochs 23) und einem vierten Verbindungskanal (gebildet durch einen Abschnitt des vierten Lochs 24). Die Kanäle bzw. Verbindungskanäle bildenden Abschnitte der Löcher werden durch das Material des Quaders und die Stopfen 26 begrenzt.

Zwei der Kanäle bilden Hinleitungskanäle, die an einem der beiden Anschlussstutzen 29 beginnen, der einen Einlass bildet, und am ersten Verbindungskanal enden, der durch einen Abschnitt des zweiten Lochs 22 gebildet ist. Die beiden anderen Kanäle bilden Rückleitungskanäle, die an dem ersten Verbindungskanal beginnen und einen in dem anderen der beiden Anschlussstutzen 29 enden. Dieser Anschlussstutzen bildet dann einen Auslass. Ein Kühlmedium kann nun den Kühlkörper vom Einlass zum Auslass durchströmen.

Bei einer alternativen Gestaltung wäre es beispielsweise möglich, die Stopfen 26, die die ersten Löcher 21 verschließen, und in den Stirnseiten des Quaders eingeschraubt sind, zu entfernen, und sie durch Anschlussstutzen zu ersetzen. Das Kühlmedium kann dann, sofern die bisherigen Anschlussstutzen 29 durch Stopfen ersetzt worden sind, von einer Stirnseite zur anderen Stirnseite den Kühlkörper durchströmen und sodann eine größere Wärmemenge aus dem Kühlkörper führen. So kann der Kühlkörper mit einfachen Mitteln an die zu erwartende thermische Last angepasst werden.

## Patentansprüche

1. Leistungselektronikbaugruppe (1 , 2, 3) mit einem Kühlkörper (2), einem Leistungshalbleitermodul (1) und einer Schaltungsanordnung (3) zum Ansteuern des Leistungshalbleitermoduls,
**dadurch gekennzeichnet, dass**
der Kühlkörper (2) wenigstens zwei parallele Kanäle aufweist, die von einem Kühlmedium durchströmbar sind.

2. Leistungselektronikbaugruppe (1 , 2, 3) nach Anspruch 1 ,
**dadurch gekennzeichnet, dass** die Kanäle durch wenigstens einen ersten Verbindungskanal miteinander verbunden sind.

3. Leistungselektronikbaugruppe (1 , 2, 3) nach Anspruch 2,
**dadurch gekennzeichnet, dass** eine erste Anzahl von ersten benachbarten Kanälen der Kanäle Hinleitungskanäle bilden, die Endbereiche aufweisen, die über den ersten Verbindungskanal miteinander verbunden sind und dass eine zweite Anzahl von zweiten benachbarten Kanälen der Kanäle Rückleitungskanäle bilden, die Anfangsbereiche aufweisen, die über den ersten Verbindungskanal miteinander und mit den Endbereichen der Hinleitungskanäle verbunden sind.

4. Leistungselektronikbaugruppe (1 , 2, 3) nach Anspruch 3,
**dadurch gekennzeichnet, dass** die erste Anzahl und die zweite Anzahl gleich sind.

5. Leistungselektronikbaugruppe (1 , 2, 3) nach Anspruch 3 oder 4,
**dadurch gekennzeichnet, dass** Anfangsbereiche der Hinleitungskanäle über einen zweiten Verbindungskanal verbunden sind.

6. Leistungselektronikbaugruppe (1 , 2, 3) nach einem der Ansprüche 3 bis 5, **dadurch gekennzeichnet, dass** die Endbereiche der Rückleitungskanäle über dritte Verbindungskanäle verbunden sind.

7. Leistungselektronikbaugruppe (1, 2, 3) nach einem der Ansprüche 1 bis 6, **dadurch gekennzeichnet, dass** die Kanäle und/oder die Verbindungskanäle Abschnitte von Durchgangslöchern (21, 22) und/oder Sacklöchern (23, 24) in einem den Kühlkörper (2) bildenden Festkörper, zum Beispiel einem Block oder einem Strangpressprofil sind.

8. Leistungselektronikbaugruppe (1 , 2, 3) nach Anspruch 7, **dadurch gekennzeichnet, dass** durch Stopfen (26), Schrauben oder Ähnliches und den Festkörper die Abschnitte der Durchgangslöcher (21,22) und/oder Sacklöcher (23, 24) abgegrenzt sind.

9. Leistungselektronikbaugruppe (1 , 2, 3) nach Anspruch 8, **dadurch gekennzeichnet, dass** die Stopfen (26), Schrauben oder Ähnliches lösbar und/oder eingeklebt in dem Festkörper eingesetzt sind.

10. Leistungselektronikbaugruppe (1 , 2, 3) nach einem der Ansprüche 1 bis 9, **dadurch gekennzeichnet, dass** das Leistungshalbleitermodul (1) auf dem Kühlkörper (2) befestigt ist.

11. Leistungselektronikbaugruppe (1 , 2, 3) nach einem der Ansprüche 1 bis 10, **dadurch gekennzeichnet, dass** die Schaltungsanordnung (3) zum Ansteuern des Leistungshalbleitermoduls (1) einen Schaltungsträger (31) umfasst, der über Abstandhalter (33) mit Abstand zu einer Oberfläche des Kühlkörpers (2) an dem Kühlkörper (2) befestigt ist.

12. Leistungselektronikbaugruppe (1 , 2, 3) nach einem der Ansprüche 1 bis 1 1 , **dadurch gekennzeichnet, dass** der Kühlkörper (2) Bohrungen (28) oder auf einer dem Leistungshalbleitermodul (1) abgewandten Seite wenigstens eine Nut, wenigstens eine Bohrung oder ähnliches aufweist, in welcher Befestigungsmittel zur Befestigung der Leistungselektronikbaugruppe (1 , 2, 3) an einem Träger aufweist.

13. Anordnung (A) umfassend mehrere
Leistungselektronikbaugruppen (1 , 2, 3) nach einem der Ansprüche 1 bis 11.

14. Anordnung (A) nach Anspruch 12, **dadurch gekennzeichnet, dass** die Anordnung (A) ein Wechselrichter oder ein vorzugsweise getakteter Gleichrichter ist.

15. Anordnung (A) nach Anspruch 12 oder 13, **dadurch gekennzeichnet, dass** die Leistungselektronikbaugruppen (1 , 2, 3) so zu einander angeordnet sind, dass die Kanäle parallel zu einander liegen.

16. Anordnung (A) nach einem der Ansprüche 13 bis 15, **dadurch gekennzeichnet, dass** die Anordnung (A) Zuleitungen und Ableitungen für ein Kühlmedium aufweist, die über in den Anfangsbereichen der Hinleitungskanäle bzw. in den Endbereichen der Rückleitungskanäle vorgesehenen Anschlüsse an die Hinleitungskanäle bzw. die Rückleitungskanäle angeschlossen sind.

17. Anordnung (A) nach Anspruch 16, **dadurch gekennzeichnet, dass** die Leistungselektronikbaugruppen (1 , 2, 3) fluidisch parallel geschaltet sind.
